# EUROPEAN PATENT APPLICATION

(11) **EP 4 333 079 A1**
(43) Date of publication of application: **06.03.2024**
(21) Application number: 22795239.7
(22) Date of filing: 18.02.2022
(51) Int. Cl.: H01L 29/82, G01R 33/02, H01L 43/00

(54) **MAGNETIC SENSOR AND METHOD FOR DETECTING MAGNETISM**

(30) Priority: 28.04.2021 JP 2021076847
(71) Applicant: Panasonic Intellectual Property Management Co., Ltd., Kadoma-shi, Osaka 571-0057 (JP)
(72) Inventor: NISHITANI, Yu, Kadoma-shi, Osaka 571-0057 (JP)
(74) Representative: Grünecker Patent- und Rechtsanwälte PartG mbB
(86) International application number: PCT/JP2022/006557
(87) International publication number: WO 2022/230316

(57) **Abstract**

A magnetic sensor includes a waveguide 1, a first electrode 2, a second electrode 3, and a detection electrode 4. In the waveguide 1, a first position 1A, a detection position 1C, and a second position 1B are arranged in this order. The first electrode 2 excites a first spin wave 21. The first spin wave 21 is propagated from the first position 1A to the detection position 1C. The second electrode 3 excites a second spin wave 22. The second spin wave 22 is propagated from the second position 1B to the detection position 1C. The detection electrode 4 extracts a signal from the detection position 1C.

## Description

### Technical Field

The present disclosure relates to a magnetic sensor and a magnetic detection method.

### Background Art

A variety of magnetic sensors are being studied. Patent Literature 1 describes a SQUID (Superconducting Quantum Interference Device) as a magnetic sensor. Other examples of the magnetic sensor include a Hall element sensor.

### Citation List

### Patent Literature

PTL 1: Japanese Unexamined Patent Application Publication No. 2000-275312

### Summary of Invention

### Technical Problem

It is an object of the present disclosure to provide a compact and sensitive magnetic sensor.

### Solution to Problem

The present disclosure provides a magnetic sensor including:
a waveguide in which a first position, a detection position, and a second position are arranged in this order;
a first electrode that excites a first spin wave to be propagated from the first position to the detection position;
a second electrode that excites a second spin wave to be propagated from the second position to the detection position; and
a detection electrode that extracts a signal from the detection position. Advantageous Effects of Invention

The present disclosure provides a compact and sensitive magnetic sensor.

### Brief Description of Drawings

[Fig. 1A] Fig. 1A is a top view schematically illustrating a magnetic sensor according to a first embodiment.
[Fig. 1B] Fig. 1B is a sectional view schematically illustrating the magnetic sensor according to the first embodiment.
[Fig. 1C] Fig. 1C illustrates a first position, a second position, and a detection position of a waveguide according to the first embodiment.
[Fig. 2A] Fig. 2A illustrates a first spin wave and a second spin wave.
[Fig. 2B] Fig. 2B illustrates a first spin wave, a second spin wave, and an interference wave at the time when an external magnetic field of a measurement target is zero.
[Fig. 2C] Fig. 2C illustrates a first spin wave, a second spin wave, and an interference wave at the time when an external magnetic field of a measurement target is not zero.
[Fig. 3A] Fig. 3A is a top view schematically illustrating a magnetic sensor according to a first modification.
[Fig. 3B] Fig. 3B illustrates a first position, a second position, and a detection position of a waveguide according to the first modification.
[Fig. 4A] Fig. 4A is a top view schematically illustrating a magnetic sensor according to a second modification.
[Fig. 4B] Fig. 4B illustrates a first position, a second position, and a detection position of a waveguide according to the second modification.
[Fig. 5A] Fig. 5A is a top view schematically illustrating a magnetic sensor according to a second embodiment.
[Fig. 5B] Fig. 5B is a sectional view schematically illustrating the magnetic sensor according to the second embodiment.
[Fig. 5C] Fig. 5C illustrates a first position, a second position, and a detection position of a waveguide according to the second embodiment.
[Fig. 6A] Fig. 6A is a top view schematically illustrating a magnetic sensor according to a third embodiment.
[Fig. 6B] Fig. 6B is a sectional view schematically illustrating the magnetic sensor according to the third embodiment.
[Fig. 6C] Fig. 6C illustrates a first position, a second position, and a detection position of a waveguide according to the third embodiment.
[Fig. 7] Fig. 7 is a perspective view schematically illustrating a magnetic sensor according to a fourth embodiment.
[Fig. 8] Fig. 8 schematically illustrates additional components.
[Fig. 9] Fig. 9 is a perspective view schematically illustrating a magnetic sensor according to a fifth embodiment.
[Fig. 10] Fig. 10 is a perspective view schematically illustrating a magnetic sensor according to Example 1.
[Fig. 11] Fig. 11 illustrates the relationship between the magnitude of a magnetic field applied by a second electromagnet and the amplitude of a voltage detected by a detection electrode.
[Fig. 12A] Fig. 12A is a perspective view illustrating a magnetic sensor according to a reference form.
[Fig. 12B] Fig. 12B is a perspective view illustrating a magnetic sensor that uses the waveguide according to the first to fifth embodiments.

### Description of Embodiments

### (Underlying Knowledge Forming Basis of the Present Disclosure)

There is known a phenomenon in which the phases of adjacent spins in a magnetic substance are shifted from each other to cause precession of the spins. Phase information during the precession is propagated in the magnetic substance as waves. The waves are called spin waves. The spin waves may be propagated in ferromagnetic substances and antiferromagnetic substances. According to the examination by the inventor, it is possible to implement a compact and sensitive magnetic sensor by taking advantage of the fact that the physical properties of spin waves are varied by a magnetic field.

### (Overview of One Aspect of the Present Disclosure)

A first aspect of the present disclosure provides a magnetic sensor including:
a waveguide in which a first position, a detection position, and a second position are arranged in this order;
a first electrode that excites a first spin wave to be propagated from the first position to the detection position;
a second electrode that excites a second spin wave to be propagated from the second position to the detection position; and
a detection electrode that extracts a signal from the detection position.

With the first aspect, it is possible to provide a compact and sensitive magnetic sensor.

In a second aspect of the present disclosure, for example, in the magnetic sensor according to the first aspect,
a distance from the first position to the detection position may be defined as a first distance,
a distance from the second position to the detection position may be defined as a second distance, and
the first distance and the second distance may be different from each other.

With the second aspect, magnetic detection can be performed easily with a small bias magnetic field.

In a third aspect of the present disclosure, for example, in the magnetic sensor according to the first or second aspect,
the first position, the second position, and the detection position may be arranged on a line.

With the third aspect, magnetic detection can be performed easily with a small bias magnetic field.

In a fourth aspect of the present disclosure, for example, the magnetic sensor according to any one of the first to third aspects may further include at least one alternating-current power source connected to the first electrode and the second electrode.

The at least one alternating-current power source according to the fourth aspect can excite a first spin wave and a second spin wave.

In a fifth aspect of the present disclosure, for example, the magnetic sensor according to any one of the first to fourth aspects may further include a detector connected to the detection electrode.

The detector according to the fifth aspect can detect a signal.

In a sixth aspect of the present disclosure, for example, the magnetic sensor according to any one of the first to fifth aspects may further include a magnetic field source that applies a bias magnetic field to the waveguide.

The magnetic field source according to the sixth aspect can apply a bias magnetic field to the waveguide.

In a seventh aspect of the present disclosure, for example, in the magnetic sensor according to the sixth aspect,
the waveguide may have a film shape, and
the magnetic field source may apply the bias magnetic field in an intersecting direction that intersects a thickness direction of the film shape.

The direction of application of the bias magnetic field according to the seventh aspect is an example of the direction of application of the bias magnetic field.

In an eighth aspect of the present disclosure, for example, in the magnetic sensor according to the seventh aspect,
the intersecting direction may be a direction that connects between the first position and the second position.

The direction of application of the bias magnetic field according to the eighth aspect is a specific example of the direction of application of the bias magnetic field.

In a ninth aspect of the present disclosure, for example, in the magnetic sensor according to the seventh aspect,
the intersecting direction may be a direction that is orthogonal to a direction that connects between the first position and the second position.

The direction of application of the bias magnetic field according to the ninth aspect is a specific example of the direction of application of the bias magnetic field.

In a tenth aspect of the present disclosure, for example, in the magnetic sensor according to the sixth aspect,
the waveguide may have a film shape, and
the magnetic field source may apply the bias magnetic field in the thickness direction of the film shape.

The direction of application of the bias magnetic field according to the tenth aspect is a specific example of the direction of application of the bias magnetic field.

In an eleventh aspect of the present disclosure, for example, in the magnetic sensor according to any one of the first to tenth aspects,
the waveguide may have a film shape, and
a longitudinal direction of the film shape may be a direction that connects between the first position and the second position.

The shape according to the eleventh aspect is an example of the shape of the magnetic sensor.

In a twelfth aspect of the present disclosure, for example, in the magnetic sensor according to any one of the first to eleventh aspects,
the waveguide may contain yttrium iron garnet.

Yttrium iron garnet is an example of a material contained in the waveguide.

In a thirteenth aspect of the present disclosure, for example, in the magnetic sensor according to any one of the first to twelfth aspects,
the first spin wave and the second spin wave may be surface spin waves, and
the first spin wave and the second spin wave may be backward volume spin waves, or
the first spin wave and the second spin wave may be forward volume spin waves.

The spin waves according to the thirteenth aspect are specific examples of the spin waves.

A fourteenth aspect of the present disclosure provides a magnetic detection method including
using a waveguide, in which a first position, a detection position, and a second position are arranged in this order, to
excite a first spin wave to be propagated from the first position to the detection position and a second spin wave to be propagated from the second position to the detection position, and
extract a signal from the detection position.

A magnetic sensor that implements the detection method according to the fourteenth aspect may be a compact and sensitive magnetic sensor.

Embodiments of the present disclosure will be described in detail below with reference to the drawings. The following embodiments are exemplary, and the present disclosure is not limited to the following embodiments.

### (First Embodiment)

A magnetic sensor according to a first embodiment will be described below.

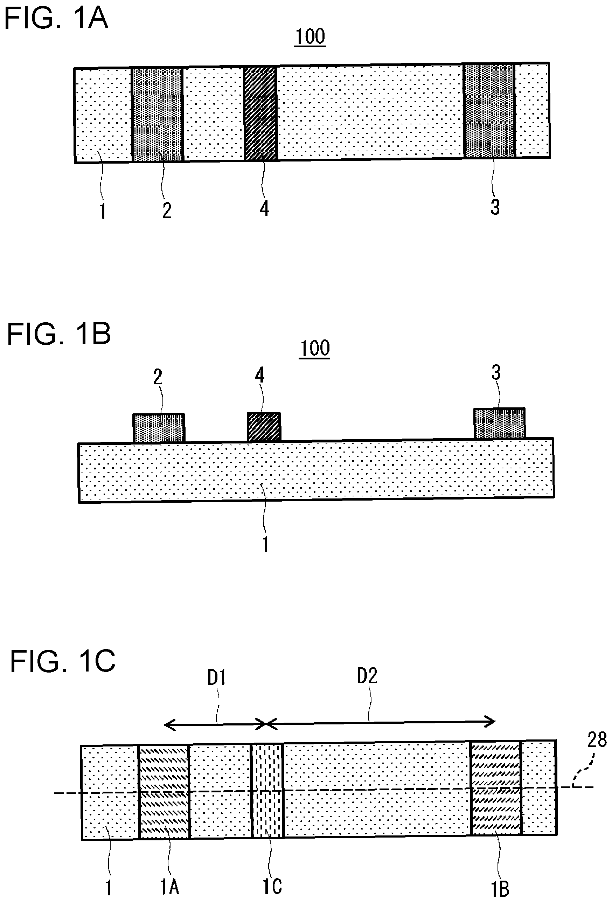

Fig. 1A is a top view schematically illustrating a magnetic sensor 100 according to the first embodiment. Fig. 1B is a sectional view schematically illustrating the magnetic sensor 100 according to the first embodiment.

As illustrates in Figs. 1A and 1B, the magnetic sensor 100 includes a waveguide 1, a first electrode 2, a second electrode 3, and a detection electrode 4. The first electrode 2, the second electrode 3, and the detection electrode 4 are provided on the waveguide 1. Specifically, the first electrode 2, the second electrode 3, and the detection electrode 4 are provided on the front surface of the waveguide 1. On the waveguide 1, the detection electrode 4 is provided between the first electrode 2 and the second electrode 3.

The waveguide 1 propagates spin waves. The waveguide 1 may also be referred to as a spin wave propagation layer. The first electrode 2 may also be referred to as a first excitation electrode. The second electrode 3 may also be referred to as a second excitation electrode.

The material that constitutes the first electrode 2, the second electrode 3, and the detection electrode 4 is a conductor. Examples of the conductor include Au (gold), Ag (silver), Cu (copper), Al (aluminum), Pt (platinum), C (carbon), etc.

The waveguide 1 contains at least one selected from the group consisting of ferromagnetic substances and antiferromagnetic substances, for example. The ferromagnetic substances and the antiferromagnetic substances can propagate spin waves. The waveguide 1 may contain only a ferromagnetic substance, among the ferromagnetic substances and the antiferromagnetic substances. The waveguide 1 may contain only an antiferromagnetic substance, among the ferromagnetic substances and the antiferromagnetic substances. The waveguide 1 may contain both a ferromagnetic substance and an antiferromagnetic substance. Specifically, the waveguide 1 may be a structure in which a layer of a ferromagnetic substance and a layer of an antiferromagnetic substance are stacked on each other.

Examples of the ferromagnetic substances include Y₃Fe₅O₁₂ (yttrium iron garnet), (Y,Bi)₃Fe₅O₁₂, Lu₃Fe₅O₁₂, (Ni,Zn)(Fe,Al)₂O₄, Mg(Fe,Al)₂O₄, Li_{0.5}Fe_{2.5}O₄, (La,Sr)MnO₃, Fe, Co, Ni, NiFe (permalloy), CoFe, CoFeB, CoNi, GdCo, etc. Examples of the antiferromagnetic substances include NiOₓ, Cr₂O₃, YMnO₃, etc. In the present embodiment, the waveguide 1 contains yttrium iron garnet.

In the present embodiment, the waveguide 1 is an insulator or a dielectric. With this configuration, the magnetic sensor 100 can operate as a sensor without the need to provide an insulator or a dielectric between the electrodes 2, 3, and 4 and the waveguide 1, separately from the waveguide 1. This is advantageous from the viewpoint of implementing a low-cost magnetic sensor.

The magnetic sensor 100 according to the present embodiment will be further described below with reference to Fig. 1C etc. using terms including a first position, a detection position, a second position, a first spin wave, a second spin wave, an interference wave, etc. Fig. 1C illustrates a first position 1A, a second position 1B, and a detection position 1C of the waveguide 1 according to the first embodiment.

The magnetic sensor 100 includes the waveguide 1, the first electrode 2, the second electrode 3, and the detection electrode 4. In the waveguide 1, the first position 1A, the detection position 1C, and the second position 1B are arranged in this order. The first electrode 2 excites a first spin wave. The first spin wave is propagated from the first position 1A to the detection position 1C. The second electrode 3 excites a second spin wave. The second spin wave is propagated from the second position 1B to the detection position 1C. The detection electrode 4 extracts a signal from the detection position 1C. With this configuration, it is possible to provide a compact and sensitive magnetic sensor 100. The signal may be a voltage signal, for example.

A magnetic detection method according to the present embodiment uses the waveguide 1. In the waveguide 1, the first position 1A, the detection position 1C, and the second position 1B are arranged in this order. The detection method includes a first step and a second step. In the first step, a first spin wave and a second spin wave are excited. The first spin wave is propagated from the first position 1A to the detection position 1C. The second spin wave is propagated from the second position 1B to the detection position 1C. In the second step, a signal is extracted from the detection position 1C. A magnetic sensor that implements such a detection method may be a compact and sensitive magnetic sensor. The signal may be a voltage signal, for example.

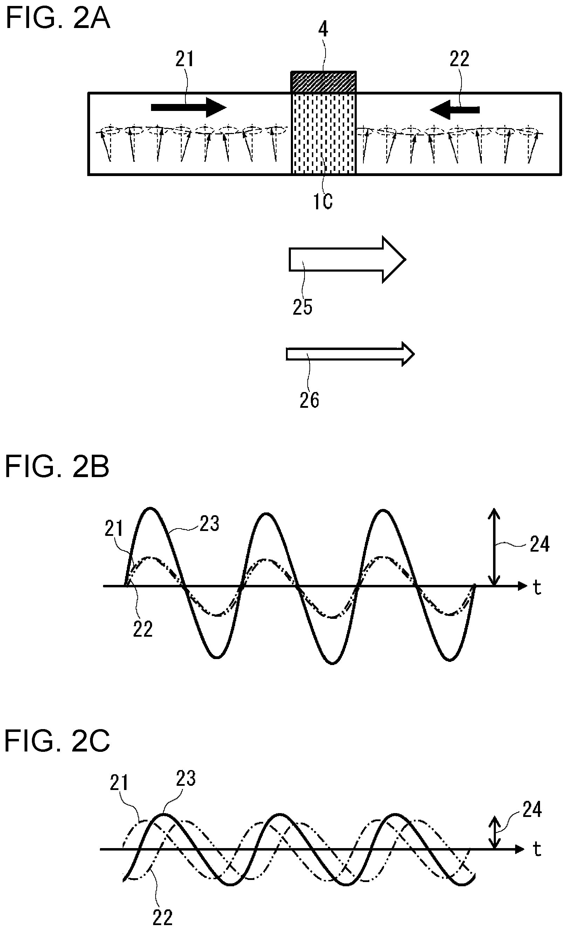

Operation of the magnetic sensor 100 will be described with reference to Fig. 2A. Fig. 2A illustrates a first spin wave 21 and a second spin wave 22. The first spin wave 21 is excited in the waveguide 1 when an alternating current is applied to the first electrode 2 with a bias magnetic field 25 applied to the waveguide 1. The second spin wave 22 is excited in the waveguide 1 when an alternating current is applied to the second electrode 3 with the bias magnetic field 25 applied to the waveguide 1. The first spin wave 21 is propagated through the waveguide 1 so as to approach the detection position 1C. The second spin wave 22 is propagated through the waveguide 1 so as to approach the detection position 1C. When the first spin wave 21 and the second spin wave 22 are formed in this manner, a signal that reflects an external magnetic field 26 can be extracted from the detection position 1C. In the example in Fig. 2A, the bias magnetic field 25 is applied in a direction that intersects the thickness direction of the electrodes 2, 3, and 4, specifically in a direction that is orthogonal to the thickness direction. The bias magnetic field 25 may be applied in the thickness direction of the electrodes 2, 3, and 4. The direction of the bias magnetic field 25 and the direction of the external magnetic field 26 may be the same as or different from each other. An alternating current is applied to the electrodes 2 and 3 by an alternating-current power source (not illustrated in Fig. 2A). The bias magnetic field 25 is applied to the waveguide 1 by a magnetic field source (not illustrated in Fig. 2A). Examples of the alternating-current power source and the magnetic field source will be described in relation to embodiments to be discussed later.

It is considered that the external magnetic field 26 is detectable by the following mechanism, although it is necessary to wait for further study for the details. The mechanism will be described with reference to Figs. 2B and 2C. Fig. 2B illustrates the first spin wave 21, the second spin wave 22, and an interference wave 23 at the time when the external magnetic field 26 of a measurement target is zero. Fig. 2C illustrates the first spin wave 21, the second spin wave 22, and the interference wave 23 at the time when the external magnetic field 26 of a measurement target is not zero. The interference wave 23 is an interference wave for the first spin wave 21 and the second spin wave 22. In Figs. 2B and 2C, the horizontal axis represents time t. The vertical axis represents the level of each wave at the detection position 1C.

As illustrated in Figs. 2B and 2C, the wave number of the first spin wave 21 and the wave number of the second spin wave 22 are varied in accordance with the external magnetic field 26. The phase difference between the spin waves 21 and 22 at the detection position 1C is varied in accordance with such variations in the wave numbers. An amplitude 24 of the interference wave 23 at the detection position 1C is varied in accordance with the phase difference. The amplitude 24 is reflected in the signal to be extracted from the detection position 1C. It is considered that the external magnetic field 26 is detectable with the signal varied in accordance with the external magnetic field 26 due to such a mechanism. The amplitude is the difference between the zero level and the peak level of a wave.

Specifically, Fig. 2B depicts an example in which the phase difference between the spin waves 21 and 22 at the detection position 1C is zero when the external magnetic field 26 is zero, and the amplitude 24 is high with the spin waves 21 and 22 intensifying each other. In contrast, Fig. 2C depicts an example in which the phase difference between the spin waves 21 and 22 at the detection position 1C is not zero when the external magnetic field 26 is not zero, and the amplitude 24 is low.

In the present embodiment, the waveguide 1 has a film shape. In the present embodiment, as can be understood from Figs. 1A and 1C, the first position 1A overlaps the first electrode 2 when the film shape is viewed in plan. The second position 1B overlaps the second electrode 3 when the film shape is viewed in plan. The detection position 1C overlaps the detection electrode 4 when the film shape is viewed in plan.

The thickness of the film shape of the waveguide 1 is 5 nm or more and 100 µm or less, for example. The thickness may be 20 nm or more and 10 µm or less.

A first distance D1 indicated in Fig. 1C is the distance from the first position 1A to the detection position 1C. A second distance D2 is the distance from the second position 1B to the detection position 1C. In the present embodiment, the first distance D1 and the second distance D2 are different from each other. With this configuration, magnetic detection can be performed easily with a small bias magnetic field 25. This is considered to be because of the following reason. When the first distance D1 is not equal to the second distance D2, there tends to be a difference between the degree to which the external magnetic field 26 varies the wave number of the first spin wave 21 and the degree to which the external magnetic field 26 varies the wave number of the second spin wave 22. Therefore, there tends to be a phase difference between the first spin wave 21 and the second spin wave 22 at the detection position 1C. Therefore, the amplitude 24 of the interference wave 23 at the detection position 1C tends to be varied by the external magnetic field 26. Therefore, even in a situation in which a phase difference is not likely to be caused by the dispersion relationship of the spin waves since the bias magnetic field 25 is small, the signal extracted from the detection position 1C tends to reflect the effect of the external magnetic field 26 as the first distance D1 and the second distance D2 are different from each other. In this context, the distances are distances between geometric centers, and are linear distances. Specifically, in the example in Fig. 1C, the first distance D1 is shorter than the second distance D2.

The first spin wave 21 and the second spin wave 22 may be surface spin waves. With this configuration, magnetic detection can be performed easily with a small bias magnetic field 25. The surface spin waves are spin waves of a surface mode. In a situation in which the spin waves 21 and 22 are surface spin waves, the bias magnetic field 25 is orthogonal to wave number vectors of the spin waves 21 and 22, and parallel to the magnetic film surface of the waveguide 1.

Alternatively, the first spin wave 21 and the second spin wave 22 may be backward volume spin waves. Also with this configuration, magnetic detection can be performed easily with a small bias magnetic field 25. The backward volume spin waves are spin waves of a backward volume mode. In a situation in which the spin waves 21 and 22 are backward volume spin waves, the bias magnetic field 25 is parallel to wave number vectors of the spin waves 21 and 22.

Alternatively, the first spin wave 21 and the second spin wave 22 may be forward volume spin waves. The forward volume spin waves are spin waves of a forward volume mode. In a situation in which the spin waves 21 and 22 are forward volume spin waves, the bias magnetic field 25 is orthogonal to wave number vectors of the spin waves 21 and 22, and orthogonal to the magnetic film surface of the waveguide 1.

In the present embodiment, the first position 1A, the second position 1B, and the detection position 1C are arranged on a line. With this configuration, the mode of the first spin wave 21 and the mode of the second spin wave 22 can be the same as each other, and the first spin wave 21 and the second spin wave 22 can be surface spin waves or backward volume spin waves. Therefore, magnetic detection can be performed easily with a small bias magnetic field 25. The reason will be discussed in detail later. Specifically, when the film shape of the waveguide 1 is viewed in plan as illustrated in Fig. 1C, a line 28 passes through the first position 1A, the second position 1B, and the detection position 1C. When the film shape of the waveguide 1 is viewed in plan, in addition, the line 28 passes through the first electrode 2, the second electrode 3, and the detection electrode 4.

In the present embodiment, the longitudinal direction of the film shape of the waveguide 1 is the direction that connects between the first position 1A and the second position 1B. The short-length direction of the film shape of the waveguide 1 is the direction that is orthogonal to the direction that connects between the first position 1A and the second position 1B. In a typical example, the longitudinal direction and the short-length direction are directions that belong to in-plane directions that are orthogonal to the thickness direction of the film shape. Specifically, the film shape is a strip shape.

The first electrode 2, the second electrode 3, and the detection electrode 4 are connected to the waveguide 1 not via an insulator or a dielectric. In the illustrated example, the first electrode 2, the second electrode 3, and the detection electrode 4 are in direct contact with the waveguide 1. This configuration is simple.

In the present embodiment, the first electrode 2, the second electrode 3, and the detection electrode 4 constitute an antenna. Specifically, the first electrode 2, the second electrode 3, and the detection electrode 4 constitute a micro-strip antenna.

The shape of the waveguide 1 is changeable as appropriate. The shapes of the first electrode 2, the second electrode 3, and the detection electrode 4 are changeable as appropriate. In addition, the positional relationship among the first position 1A, the second position 1B, and the detection position 1C is changeable as appropriate.

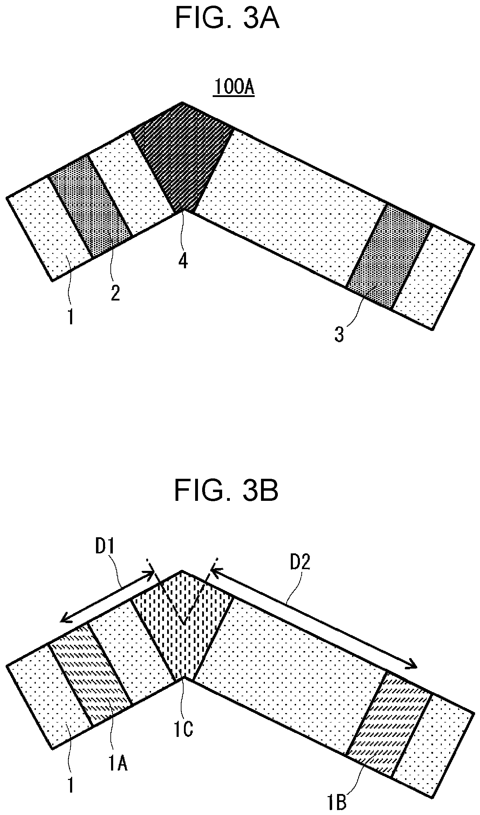

Fig. 3A is a top view schematically illustrating a magnetic sensor 100A according to a first modification. Fig. 3B illustrates a first position 1A, a second position 1B, and a detection position 1C of a waveguide 1 according to the first modification. In the first modification, as illustrated in Fig. 3B, the film shape of the waveguide 1 is a dogleg shape when the film shape is viewed in plan. Also in the waveguide 1 according to the first modification, the first position 1A, the detection position 1C, and the second position 1B are arranged in this order.

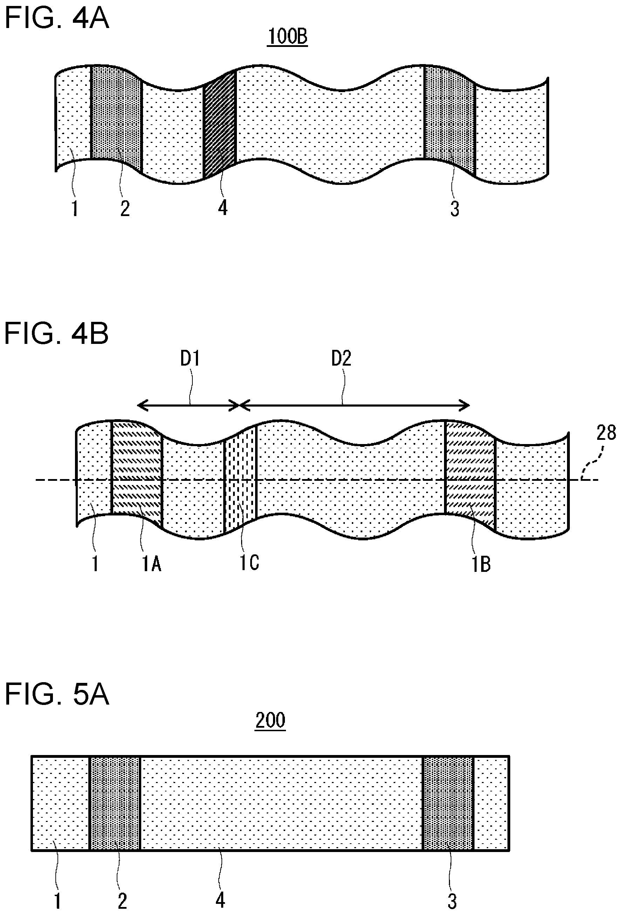

Fig. 4A is a top view schematically illustrating a magnetic sensor 100B according to a second modification. Fig. 4B illustrates a first position 1A, a second position 1B, and a detection position 1C of a waveguide 1 according to the second modification. In the second modification, as illustrated in Fig. 4B, the film shape of the waveguide 1 is a wave shape when the film shape is viewed in plan. Also in the waveguide 1 according to the second modification, the first position 1A, the detection position 1C, and the second position 1B are arranged in this order. In the second modification, in addition, the first position 1A, the second position 1B, and the detection position 1C are arranged on a line.

Other embodiments will be described below. In the following, elements that are common to those of the embodiment described already and embodiments to be described later are given the same reference signs, and descriptions thereof may be omitted. Descriptions of the embodiments may be applied to each other unless any technical contradiction occurs. The embodiments may be combined with each other unless any technical contradiction occurs.

### (Second Embodiment)

A magnetic sensor according to a second embodiment will be described below.

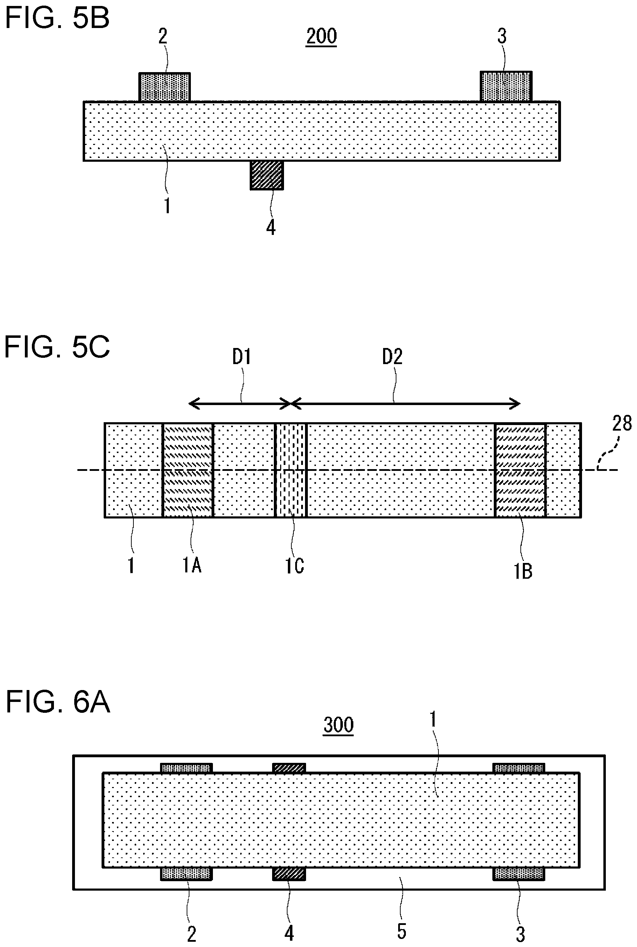

Fig. 5A is a top view schematically illustrating a magnetic sensor 200 according to the second embodiment. Fig. 5B is a sectional view schematically illustrating the magnetic sensor 200 according to the second embodiment. Fig. 5C illustrates a first position 1A, a second position 1B, and a detection position 1C of a waveguide 1 according to the second embodiment.

Also in the waveguide 1 according to the second embodiment, as illustrated in Fig. 5C, the first position 1A, the detection position 1C, and the second position 1B are arranged in this order.

At least one selected from the group consisting of the first electrode 2, the second electrode 3, and the detection electrode 4 may be provided on the front surface of the waveguide 1. At least another one selected from the group consisting of the first electrode 2, the second electrode 3, and the detection electrode 4 may be provided on the back surface of the waveguide 1.

In the second embodiment, the first electrode 2 and the second electrode 3 are provided on the front surface of the waveguide 1. The detection electrode 4 is provided on the back surface of the waveguide 1.

### (Third Embodiment)

A magnetic sensor according to a third embodiment will be described below.

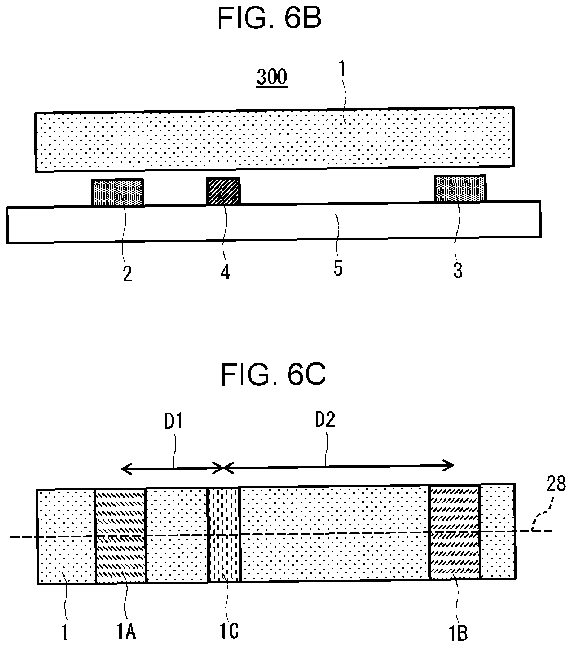

Fig. 6A is a top view schematically illustrating a magnetic sensor 300 according to the third embodiment. Fig. 6B is a sectional view schematically illustrating the magnetic sensor 300 according to the third embodiment. Fig. 6C illustrates a first position 1A, a second position 1B, and a detection position 1C of a waveguide 1 according to the third embodiment.

Also in the waveguide 1 according to the third embodiment, as illustrated in Fig. 6C, the first position 1A, the detection position 1C, and the second position 1B are arranged in this order.

The first electrode 2, the second electrode 3, and the detection electrode 4 may not be in direct contact with the waveguide 1. For example, there may be a gap between the first electrode 2 and the waveguide 1. There may be a gap between the second electrode 3 and the waveguide 1. There may be a gap between the detection electrode 4 and the waveguide 1. The width of the gap between the electrodes and the waveguide 1 is greater than 0 and 1 cm or less, for example. In this context, the width of the gap refers to the distance between the waveguide 1 and the electrodes.

The first electrode 2 and the waveguide 1 may or may not be electrically connected to each other. The second electrode 3 and the waveguide 1 may or may not be electrically connected to each other. The detection electrode 4 and the waveguide 1 may or may not be electrically connected to each other.

For example, there may be an intervening object between the first electrode 2 and the waveguide 1. There may be an intervening object between the second electrode 3 and the waveguide 1. There may be an intervening object between the detection electrode 4 and the waveguide 1. Examples of the intervening object include a sheet.

In the third embodiment, the magnetic sensor 300 includes a support body 5. The first electrode 2, the second electrode 3, and the detection electrode 4 are provided on the support body 5. There is a gap between the first electrode 2 and the waveguide 1. There is a gap between the second electrode 3 and the waveguide 1. There is a gap between the detection electrode 4 and the waveguide 1.

In a modification, the first electrode 2, the second electrode 3, and the detection electrode 4 are provided on the support body 5. The waveguide 1 is placed on the support body 5 on which the first electrode 2, the second electrode 3, and the detection electrode 4 are provided. However, the waveguide 1 and the support body 5 on which the first electrode 2, the second electrode 3, and the detection electrode 4 are provided are not joined to each other.

### (Fourth Embodiment)

A magnetic sensor according to a fourth embodiment will be described below.

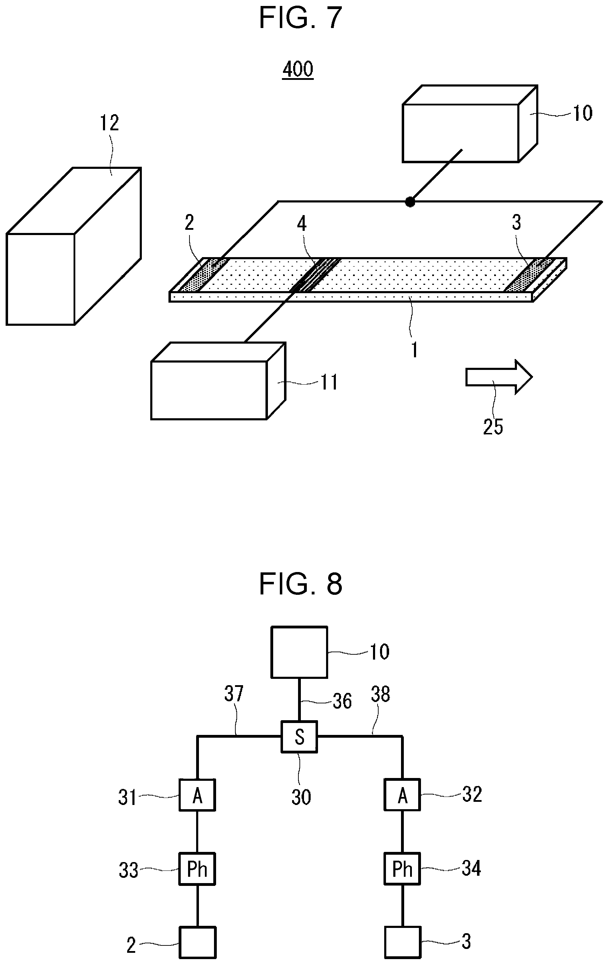

Fig. 7 is a perspective view schematically illustrating the magnetic sensor according to the fourth embodiment.

As illustrates in Fig.7, a magnetic sensor 400 includes an alternating-current power source 10, a detector 11, and a magnetic field source 12. The alternating-current power source 10 is connected to the first electrode 2 and the second electrode 3. The detector 11 is connected to the detection electrode 4. The magnetic field source 12 applies the bias magnetic field 25 to the waveguide 1. In the present embodiment, the bias magnetic field 25 is a static magnetic field.

The magnitude of the bias magnetic field 25 is 800 oersted (Oe) or less, for example. The magnitude of the bias magnetic field 25 is 400 Oe or more, for example. In one numerical example, the magnitude of the bias magnetic field 25 is about 600 Oe.

In the fourth embodiment, the magnetic field source 12 applies a bias magnetic field 25 in an intersecting direction that intersects the thickness direction of the film shape of the waveguide 1. The intersecting direction is specifically an in-plane direction that is orthogonal to the thickness direction of the film shape. In the example in Fig. 7, the intersecting direction is the direction that connects between the first position 1A and the second position 1B. In addition, the magnetic field source 12 is disposed on a line that connects between the first electrode 2 and the second electrode 3. In the fourth embodiment, the first spin wave 21 and the second spin wave 22 can be backward volume spin waves.

The magnetic field source 12 may have a permanent magnet. The bias magnetic field 25 can be applied using a permanent magnet. In addition, the magnetic field source 12 may have a direct-current power source and a wound wire. An Oersted magnetic field generated by passing a current through the wire can be applied as the bias magnetic field 25.

The detector 11 is a voltmeter, for example. Examples of the voltmeter include an oscilloscope, a wave detection circuit, etc.

The magnetic sensor 400 may include additional components. The additional components will be described below with reference to Fig. 8. Fig. 8 schematically illustrates additional components.

In the example in Fig. 8, the magnetic sensor 400 includes a splitter 30, a first attenuator 31, a second attenuator 32, a first phase shifter 33, and a second phase shifter 34. The alternating-current power source 10 and the splitter 30 are connected to each other by a common electrical path 36. The splitter 30 and the first electrode 2 are connected to each other by a first branch electrical path 37. The splitter 30 and the second electrode 3 are connected to each other by a second branch electrical path 38. The first attenuator 31 and the first phase shifter 33 are provided on the first branch electrical path 37. The second attenuator 32 and the second phase shifter 34 are provided on the second branch electrical path 38.

The first attenuator 31 allows adjustment of the amplitude of an alternating current to be applied to the first electrode 2. The second attenuator 32 allows adjustment of the amplitude of an alternating current to be applied to the second electrode 3. The first phase shifter 33 allows adjustment of the phase of the alternating current to be applied to the first electrode 2. The second phase shifter 34 allows adjustment of the phase of the alternating current to be applied to the second electrode 3.

The first attenuator 31 and the second attenuator 32 allow adjustment of the amplitude difference between the amplitude of the alternating current to be applied to the first electrode 2 and the amplitude of the alternating current to be applied to the second electrode 3. Only one of the first attenuator 31 and the second attenuator 32 may be provided. Also in that case, the amplitude difference can be adjusted.

In one example, at least one of the first attenuator 31 and the second attenuator 32 reduces the amplitude of the alternating current to be applied to the first electrode 2 to be less than the amplitude of the alternating current to be applied to the second electrode 3. In this way, the amplitude of the first spin wave 21 and the amplitude of the second spin wave 22 at the detection position 1C at the time when the external magnetic field 26 is zero can be caused to match each other when the first distance D1 is less than the second distance D2.

The first phase shifter 33 and the second phase shifter 34 allow adjustment of the phase difference between the phase of the alternating current to be applied to the first electrode 2 and the phase of the alternating current to be applied to the second electrode 3. Only one of the first phase shifter 33 and the second phase shifter 34 may be provided. Also in that case, the phase difference can be adjusted.

In one example, at least one of the first phase shifter 33 and the second phase shifter 34 is set such that the phase of the first spin wave 21 and the phase of the second spin wave 22 at the detection position 1C at the time when the external magnetic field 26 is zero match each other.

A first amplifier may be provided in place of the first attenuator 31. A second amplifier may be provided in place of the second attenuator 32.

Two alternating-current power sources may be provided. For example, the first alternating-current power source may be connected to the first electrode 2, and the second alternating-current power source may be connected to the second electrode 3. As can be understood from this example and Fig. 7, at least one alternating-current power source may be connected to the first electrode 2 and the second electrode 3.

### (Fifth Embodiment)

A magnetic sensor according to a fifth embodiment will be described below.

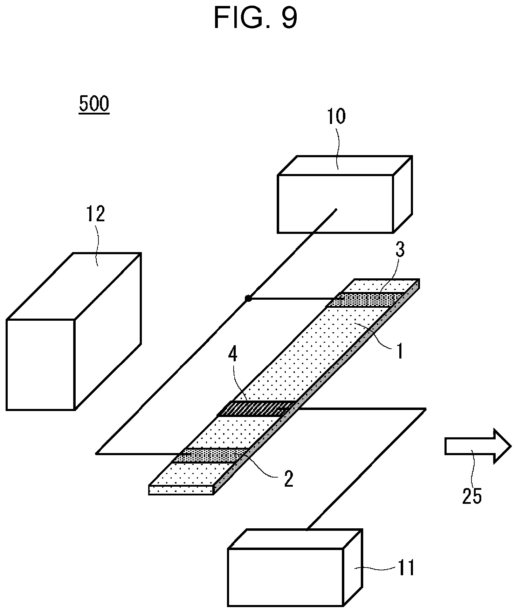

Fig. 9 is a perspective view schematically illustrating the magnetic sensor according to the fifth embodiment.

In a magnetic sensor 500 according to the fifth embodiment, as in the magnetic sensor 400 according to the fourth embodiment, the magnetic field source 12 applies a bias magnetic field 25 in an intersecting direction that intersects the thickness direction of the film shape of the waveguide 1. In the fifth embodiment, however, the intersecting direction is the direction that is orthogonal to the direction that connects between the first position 1A and the second position 1B. In the fifth embodiment, the first spin wave 21 and the second spin wave 22 can be surface spin waves.

Unlike the magnetic sensors according to the fourth and fifth embodiments, the magnetic field source 12 may apply a bias magnetic field 25 in the thickness direction of the film shape of the waveguide 1. With this configuration, the first spin wave 21 and the second spin wave 22 can be forward volume spin waves.

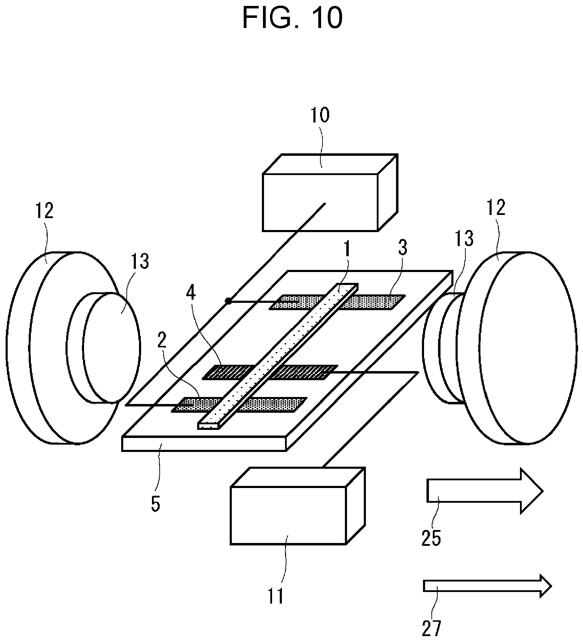

The present disclosure will be described in more detail below with reference to the following example. In the example, a magnetic sensor was fabricated, and the characteristics of the magnetic sensor were evaluated. Fig. 10 is a schematic view of the magnetic sensor according to Example 1.

### (Example 1)

### [Fabrication of Magnetic Sensor]

A conductive path 1 was provided on a GD₃Ga₅O₁₂ single-crystal substrate. The conductive path 1 was a yttrium iron garnet film (manufactured by INNOVENT Technologieentwicklung) fabricated by a liquid-phase epitaxy process. Specifically, the single-crystal substrate and the conductive path 1 were provided such that their peripheral edges coincided with each other when observed along the thickness direction.

The single-crystal substrate had a thickness of 0.5 mm, a width of 2 mm, and a length of 12 mm. In Fig. 10, the single-crystal substrate is not illustrated. The conductive path 1 had a thickness of 3.0 µm, a width of 2 mm, and a length of 12 mm.

A support body 5 on which a first electrode 2, a second electrode 3, and a detection electrode 4 were provided was prepared. The support body 5 was a printed circuit board that had a thickness of 0.2 mm, a length of 20 mm in the short-length direction, and a length of 38 mm in the longitudinal direction. Specifically, the support body 5 was MEGTRON7 (manufactured by Panasonic Corporation). The first electrode 2, the second electrode 3, and the detection electrode 4 were each a Cu thin film that had a thickness of 18 µm, a width of 75 µm, and a length of 10 mm. Specifically, p-ban.com Corporation was commissioned to mount these Cu thin films onto the support body 5.

The first electrode 2, the detection electrode 4, and the second electrode 3 were disposed in this order such that the directions of their lengths were parallel to each other. The distance from the first electrode 2 to the detection electrode 4 was 3 mm. The distance from the detection electrode 4 to the second electrode 3 was 5 mm.

The conductive path 1 was disposed on the support body 5. The conductive path 1 was disposed such that the longitudinal direction of the conductive path 1 was orthogonal to the longitudinal direction of the first electrode 1, the detection electrode 4, and the second electrode 3. The conductive path 1 was also disposed such that the first electrode 2, the detection electrode 4, and the second electrode 3 faced the conductive path 1, that is, a yttrium iron garnet film. Specifically, the conductive path 1 was placed on the support body 5 without being joined to the support body 5 and the electrodes 2, 3, and 4.

An alternating-current power source 10 was connected to the first electrode 2 and the second electrode 3 via a splitter (873008 manufactured by Agilent Technologies, Inc.). A phase shifter (6705K-2 manufactured by SAGE LABS) was connected between the splitter and the second electrode. The alternating-current power source 10 was a signal generator (83732B manufactured by Agilent Technologies, Inc.). A detector 11 was connected to the detection electrode 4. The detector 11 was an oscilloscope (infiniium 54855A manufactured by Agilent Technologies, Inc.).

As a result, a magnetic sensor according to Example 1 was obtained.

### [Evaluation of Sensor Sensitivity]

The magnetic field sensitivity (unit: V/T) of the magnetic sensor according to Example 1 was evaluated from the detection voltage from the detection electrode 4 for application of a micro-magnetic field 27. The micro-magnetic field 27 simulates the external magnetic field 26.

A first magnetic field source 12 and a second magnetic field source 13 were prepared. The first magnetic field source 12 was a pair of first electromagnets (Tesla Co., Ltd.). The first magnetic field source 12 was provided to apply the bias magnetic field 25. The second magnetic field source 13 was a pair of second electromagnets (self-made). The second magnetic field source 13 was provided to apply the micro-magnetic field 27. Each of the pair of second electromagnets was obtained by winding an enamel wire with a diameter of 0.2 mm around a wheel with a diameter of 5 cm 200 times. The pair of second electromagnets were installed in a gap between the pair of first electromagnets. Then, a printed circuit board 5 and the conductive path 1 were provided in a gap between the pair of second electromagnets. These were disposed side by side in the short-length direction of the conductive path 1.

A first direct-current power source (PBX20-20 manufactured by Kikusui Electronics Corporation) was connected to the first magnetic field source 12. A second direct-current power source (7651 manufactured by Yokogawa Electric Corporation) was connected to the second magnetic field source 13. The magnetic field applied at the position through which a line that connects between the gap center of one of the second electromagnets and the gap center of the other second electromagnet passes was the sum of the magnetic field applied from the first magnetic field source 12 and the magnetic field applied from the second magnetic field source 13. The values of the magnetic fields were controlled by the currents that flow from the first direct-current power source and the second direct-current power source.

The printed circuit board 5 was disposed at the position through which a line that connects between the gap center of one of the second electromagnets and the gap center of the other second electromagnet passes. As a result, a bias magnetic field 25 and a micro-magnetic field 27 in the short-length direction of the conduction path 1 were applied to the conductive path 1 from the first magnetic field source 12 and the second magnetic field source 13.

An alternating current was caused to flow from the alternating-current power source 10 to the first electrode 2 and the second electrode 3 while the first magnetic field source 12 was applying a bias magnetic field 25 of 600 Oe. At this time, the output frequency of the alternating-current power source 10 was set to 3.443 GHz, and the output power was set to 13.0 dBm. In this state, the magnitude of the micro-magnetic field 27 superimposed by the second magnetic field source 13 was varied in the range from 0 to 1 Oe. The amplitude of the alternating-current voltage generated at the detection electrode 4 at this time was measured. All measurements were carried out at room temperature. The room temperature was 20°C.

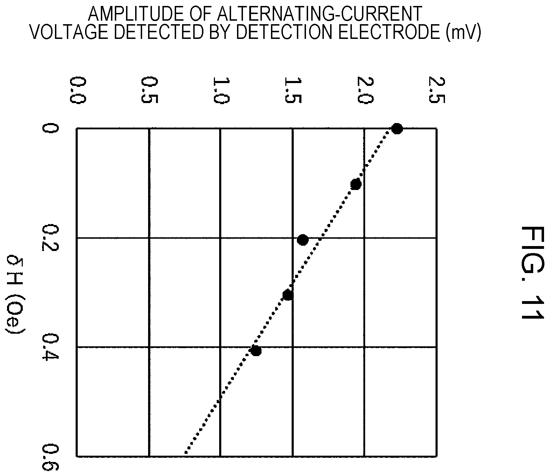

Fig. 11 illustrates the relationship between a magnitude δH of the micro-magnetic field 27 applied by the second electromagnet and the amplitude of the alternating-current voltage detected by the detection electrode 4. In Fig. 11, the horizontal axis represents the magnitude δH of the micro-magnetic field 27, which is given in the unit of Oe. The vertical axis represents the amplitude of the alternating-current voltage detected by the detection electrode 4, which is given in the unit of mV.

As illustrated in Fig.11, the detected alternating-current voltage was varied linearly with respect to the magnitude δH of the micro-magnetic field 27. Thus, it can be seen that the magnetic sensor according to Example 1 has the function of a sensor that can detect a magnetic field from a detected alternating-current voltage. The detection sensitivity, which is the rate of variation in the detected alternating-current voltage with respect to the magnitude δH of the micro-magnetic field 27, is grasped from the slope of the graph in Fig. 11. The detection sensitivity was 24 V/T, that is, 2.4 mV/Oe.

With the present disclosure, as described above, it is possible to implement a magnetic sensor that can be driven with a small bias magnetic field 25 and that has high sensitivity.

### (Comparison between Reference Form and Embodiments)

In the first to fifth embodiments, as discussed above, the first position 1A, the second position 1B, and the detection position 1C are arranged on a line. In addition, the first distance D1 and the second distance D2 are different from each other. With this configuration, magnetic detection can be performed easily with a small bias magnetic field 25. This respect will be further described in comparison to a reference form.

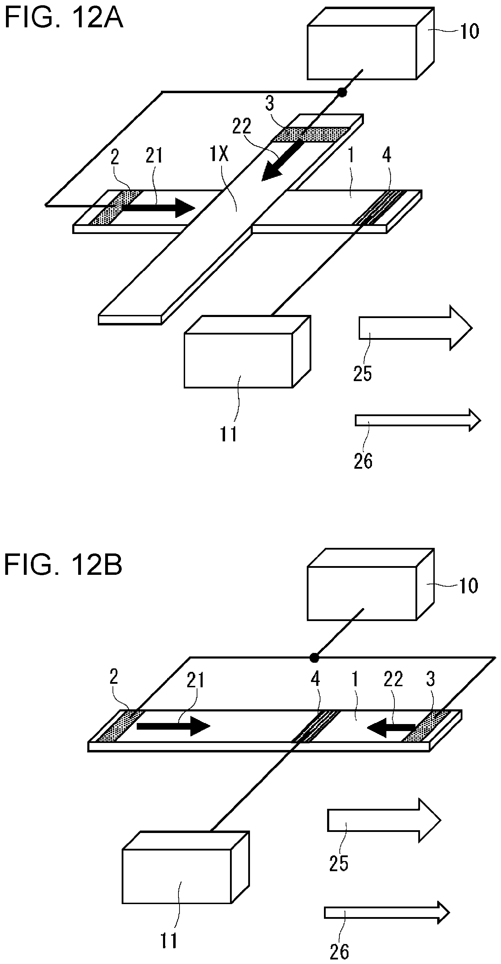

Fig. 12A is a perspective view illustrating a magnetic sensor according to a reference form. In this magnetic sensor, the film shape of the waveguide 1 is cross-shaped when the film shape is viewed in plan. The cross-shaped waveguide 1 has four end portions. The first electrode 2 is provided at a first end portion, of the four end portions. The second electrode 3 is provided at a second end portion, of the four end portions. The detection electrode 4 is provided at a third end portion, of the four end portions. The second end portion is at an angular position 90 degrees different from that of the first end portion. In other words, the second end portion is an end portion that is adjacent to the first end portion. The third end portion is an end portion located at an angular position 180 degrees different from that of the first end portion. In other words, the third end portion is an end portion positioned on an extension of a line that extends from the first end portion to an intersecting portion 1X in a cross shape.

In the configuration in Fig.12A, the first spin wave 21 and the second spin wave 22 are propagated toward the cross-shaped intersecting portion 1X, and interfere with each other at the intersecting portion 1X. The phase difference between the first spin wave 21 and the second spin wave 22 at the intersecting portion 1X is varied in accordance with the external magnetic field 26. A signal that reflects this phase difference is extracted from the detection electrode 4. With such a mechanism, the external magnetic field 26 is detected.

In the configuration in Fig. 12A, the first spin wave 21 is propagated in a direction that is parallel to the bias magnetic field 25. On the other hand, the second spin wave 22 is propagated in a direction that is orthogonal to the bias magnetic field 25. In this case, it is difficult to reduce the bias magnetic field 25 required to detect the external magnetic field 26. This is because the mode of the first spin wave 21 and the mode of the second spin wave 22 are not the same as each other. Specifically, in the example in Fig. 12A, the first spin wave 21 is a backward volume spin wave. The second spin wave 22 is a surface spin wave.

In the waveguide 1 according to the first to fifth embodiments, in contrast, the first position 1A, the second position 1B, and the detection position 1C are arranged on a line. Fig. 12B is a perspective view illustrating a magnetic sensor that uses the waveguide 1 according to the first to fifth embodiments. In the configuration in Fig. 12B, the first spin wave 21 is propagated from the first position 1A toward the detection position 1C. The second spin wave 22 is propagated from the second position 1B toward the detection position 1C. The first spin wave 21 and the second spin wave 22 interfere with each other at the detection position 1C. The phase difference between the first spin wave 21 and the second spin wave 22 is caused in accordance with the external magnetic field 26, and a signal that reflects this phase difference is extracted from the detection electrode 4. With such a mechanism, the external magnetic field 26 is detected.

In the configuration in Fig. 12B, both the first spin wave 21 and the second spin wave 22 are propagated in a direction that is parallel to the bias magnetic field 25. In the example in Fig. 12B, both the first spin wave 21 and the second spin wave 22 are backward volume spin waves. In this case, it is easy to reduce the bias magnetic field 25 required to detect the external magnetic field 26.

As can be understood from the above description, it is also possible to propagate the first spin wave 21 and the second spin wave 22 in a direction that is orthogonal to the bias magnetic field 25, as in Figs. 9 and 10. In this case, both the first spin wave 21 and the second spin wave 22 are surface spin waves. Also in this case, it is easy to reduce the bias magnetic field 25 required to detect the external magnetic field 26.

In short, with the waveguide 1 according to the first to fifth embodiments, the propagation direction of the first spin wave 21 and the second spin wave 22 can be rendered parallel to each other. Therefore, the propagation direction of the first spin wave 21 relative to the direction of application of the bias magnetic field 25 and the propagation direction of the second spin wave 22 relative to the direction of application of the bias magnetic field 25 can be the same as each other. Therefore, the mode of the first spin wave 21 and the mode of the second spin wave 22 can be the same as each other, and the first spin wave 21 and the second spin wave 22 can be surface spin waves or backward volume spin waves. This may reduce the required bias magnetic field 25. In the first to fifth embodiments, further, the first distance D1 and the second distance D2 are different from each other. This facilitates detection of a magnetic field even if the mode of the first spin wave 21 and the mode of the second spin wave 22 are the same as each other. It is possible to detect a magnetic field with a small bias magnetic field 25 when the mode of the first spin wave 21 and the mode of the second spin wave 22 are the same as each other, the first spin wave 21 and the second spin wave 22 are surface spin waves or backward volume spin waves, and the first distance D1 and second distance D2 are different from each other.

The advantage of the first spin wave 21 and the second spin wave 22 being surface spin waves or backward volume spin waves will be described. With surface spin waves and backward volume spin waves, the amplitude level can be easily secured with a small bias magnetic field 25 compared to forward volume spin waves. The reason for this may be explained as follows. The bias magnetic field 25 may cause magnetization to be performed in the direction of the bias magnetic field 25. For most materials, magnetization tends to be performed in an in-plane direction of a magnetic film surface. Therefore, a large bias magnetic field 25 is likely to be required to excite the forward volume mode by performing magnetization in a direction that is perpendicular to a magnetic film surface. In contrast, surface spin waves and backward volume spin waves may be excited with a small bias magnetic field 25. With the waveguide 1 according to the first to fifth embodiments, it is possible not only to render the modes of the spin waves 21 and 22 the same as each other, but also to use surface spin waves or backward volume spin waves as the spin waves 21 and 22. This is especially advantageous from the viewpoint of detecting a magnetic field with a small bias magnetic field 25.

According to the examination by the inventor, in the modified example in which the shape of the waveguide 1 according to Example 1 is modified into a cross shape as in Fig. 12A, a large bias magnetic field of about 1100 oersted (Oe) is required. Specifically, the magnetic sensor requires a large bias magnetic field of 1100 to 1120 Oe to excite two spin waves concurrently.

A large bias magnetic field may cause a variety of disadvantages. For example, when a large bias magnetic field is applied with a permanent magnet, a large permanent magnet is required, which increases the sensor size. For example, when a large bias magnetic field is applied with an electromagnet, a large current is required, which increases the power consumption of the sensor.

However, the magnitude of the bias magnetic field 25 of the magnetic sensor according to Example 1 is about 60% of the magnitude of the bias magnetic field of the magnetic sensor according to the modified example. That is, the magnetic sensor according to Example 1 can be advantageously driven with a bias magnetic field that is about 40% less than that for the magnetic sensor according to the modified example. In addition, the magnetic sensor according to Example 1 is 2.4 times more sensitive than the magnetic sensor according to the modified example. With the embodiment, as can be understood from the above, it is possible to implement a magnetic sensor that can be driven with a small bias magnetic field.

The magnetic sensor according to the present disclosure is expected to be used in a variety of fields. For example, the magnetic sensor is used for medical applications. In one specific example, the magnetic sensor is used to measure magnetoencephalography. Magnetoencephalography measurement can be used to identify the location of epilepsy and to identify the location of a brain tumor. In addition, the magnetic sensor may also be used for brain-machine interfaces, rehabilitation, etc.

A variety of modifications can be made to the technology related to the above description.

In the example related to the above description, the first distance D1 is less than the second distance D2. However, the first distance D1 may be more than the second distance D2.

In the example in Fig. 2B, the magnetic sensor is configured such that the phase of the first spin wave and the phase of the second spin wave at the detection position 1C at the time when the external magnetic field 26 is zero match each other. However, the magnetic sensor may be configured such that these phases are shifted from each other.

In the example in Fig. 2B, the first distance D1 is less than the second distance D2, and the amplitude of the alternating current to be applied to the first electrode 2 is less than the amplitude of the alternating current to be applied to the second electrode 3. However, the first distance D1 may be less than the second distance D2, and the amplitude of the alternating current to be applied to the first electrode 2 may be greater than the amplitude of the alternating current to be applied to the second electrode 3. Alternatively, the first distance D1 may be less than the second distance D2, and the amplitude of the alternating current to be applied to the first electrode 2 may be equal to the amplitude of the alternating current to be applied to the second electrode 3.

In the example in Fig. 10, the direction of the magnetic field applied by the first magnetic field source 12 and the direction of the magnetic field applied by the second magnetic field source 13 are the same as each other. However, the direction of the bias magnetic field 25 and the direction of the external magnetic field 26 to be measured may be the same as or different from each other.

### Industrial Applicability

The magnetic sensor according to the present disclosure can achieve high sensitivity and can be driven with a low bias magnetic field. The magnetic sensor according to the present disclosure can be driven by a compact permanent magnet. Therefore, the magnetic sensor according to the present disclosure can be used to detect operation of mechanical components that need to be installed in a small space, for example. A small magnetic field has little effect on the human body. Therefore, the magnetic sensor according to the present disclosure is useful in detecting a biomagnetic field.

### Reference Signs List

1 waveguide
1A first position
1B second position
1C detection position
1X intersecting portion
2 first electrode
3 second electrode
4 detection electrode
5 support body
10 alternating-current power source
11 detector
12 first magnetic field source
13 second magnetic field source
21 first spin wave
22 second spin wave
23 interference wave
24 amplitude
25 bias magnetic field
26 external magnetic field
27 micro-magnetic field
28 line
30 splitter
31 first attenuator
32 second attenuator
33 first phase shifter
34 second phase shifter
36 common electrical path
37 first branch electrical path
38 second branch electrical path
100, 100A, 100B, 200, 300, 400, 500 magnetic sensor
D1 first distance
D2 second distance

## Claims

1. A magnetic sensor comprising:
a waveguide in which a first position, a detection position, and a second position are arranged in this order;
a first electrode that excites a first spin wave to be propagated from the first position to the detection position;
a second electrode that excites a second spin wave to be propagated from the second position to the detection position; and
a detection electrode that extracts a signal from the detection position.

2. The magnetic sensor according to claim 1,
wherein a distance from the first position to the detection position is defined as a first distance,
a distance from the second position to the detection position is defined as a second distance, and
the first distance and the second distance are different from each other.

3. The magnetic sensor according to claim 1 or 2,
wherein the first position, the second position, and the detection position are arranged on a line.

4. The magnetic sensor according to any one of claims 1 to 3, further comprising
at least one alternating-current power source connected to the first electrode and the second electrode.

5. The magnetic sensor according to any one of claims 1 to 4, further comprising
a detector connected to the detection electrode.

6. The magnetic sensor according to any one of claims 1 to 5, further comprising
a magnetic field source that applies a bias magnetic field to the waveguide.

7. The magnetic sensor according to claim 6,
wherein the waveguide has a film shape, and
the magnetic field source applies the bias magnetic field in an intersecting direction that intersects a thickness direction of the film shape.

8. The magnetic sensor according to claim 7,
wherein the intersecting direction is a direction that connects between the first position and the second position.

9. The magnetic sensor according to claim 7,
wherein the intersecting direction is a direction that is orthogonal to a direction that connects between the first position and the second position.

10. The magnetic sensor according to claim 6,
wherein the waveguide has a film shape, and
the magnetic field source applies the bias magnetic field in the thickness direction of the film shape.

11. The magnetic sensor according to any one of claims 1 to 10,
wherein the waveguide has a film shape, and
a longitudinal direction of the film shape is a direction that connects between the first position and the second position.

12. The magnetic sensor according to any one of claims 1 to 11,
wherein the waveguide contains yttrium iron garnet.

13. The magnetic sensor according to any one of claims 1 to 12,
wherein the first spin wave and the second spin wave are surface spin waves, and
the first spin wave and the second spin wave are backward volume spin waves, or
the first spin wave and the second spin wave are forward volume spin waves.

14. A magnetic detection method comprising:
using a waveguide, in which a first position, a detection position, and a second position are arranged in this order, to
excite a first spin wave to be propagated from the first position to the detection position and a second spin wave to be propagated from the second position to the detection position, and
extract a signal from the detection position.
